# EUROPEAN PATENT SPECIFICATION

(11) **EP 1 783 895 B1**
(45) Date of publication and mention of the grant of the patent: **17.10.2018**
(21) Application number: 06022508.3
(22) Date of filing: 27.10.2006
(51) Int. Cl.: H03F 1/26, H03F 3/45, H03F 1/42, H03F 3/00

(54) **Transconductance amplifiers with compensation**
Transkonduktanzverstärker mit Kompensation
Amplificateurs de transconductance avec compensation

(30) Priority: 02.11.2005 US 264921; 02.12.2005 US 292436; 02.12.2005 US 292589
(43) Date of publication of application: 09.05.2007
(73) Proprietor: Marvell World Trade Ltd., St. Michael 14027 (BB)
(72) Inventor: Sutardja, Sehat, Los Altos Hills California 94022 (US); Aram, Farbod, Los Altos Hills alifornia 94022 (US)
(74) Representative: Grünecker Patent- und Rechtsanwälte PartG mbB

(56) References cited:
- US-A- 5 880 634
- US-A- 5 990 748
- PENG X ET AL: "AC Boosting Compensation Scheme for Low-Power Multistage Amplifiers" IEEE JOURNAL OF SOLID-STATE CIRCUITS, IEEE SERVICE CENTER, PISCATAWAY, NJ, US, vol. 39, no. 11, 1 November 2004 (2004-11-01), pages 2074-2079, XP011121139 ISSN: 0018-9200

## Description

### FIELD OF THE INVENTION

The present invention relates to amplifiers, and more particularly to amplifiers with compensation.

### BACKGROUND OF THE INVENTION

An amplifier may include one or more stages. Each stage may include an amplifier that provides gain. As frequency increases, the gain that is provided by the amplifier tends to fall off, which limits the bandwidth of the amplifier. As operating frequencies of electronic computing devices increase, amplifiers having high bandwidth and gain and low noise have become increasingly important.

Miller compensation is a conventional frequency compensation technique that involves the movement of a dominant pole of a gain stage to a lower frequency by increasing the effective Input capacitance of the gain stage. Miller compensation circuits include a Miller capacitance that exploits the Miller effect. When the Miller capacitance is connected in a feedback arrangement, the capacitance appears much larger at the input of the amplifier. While the dominant pole may be moved to a lower frequency using this approach, the gain and bandwidth of the system is still somewhat limited.

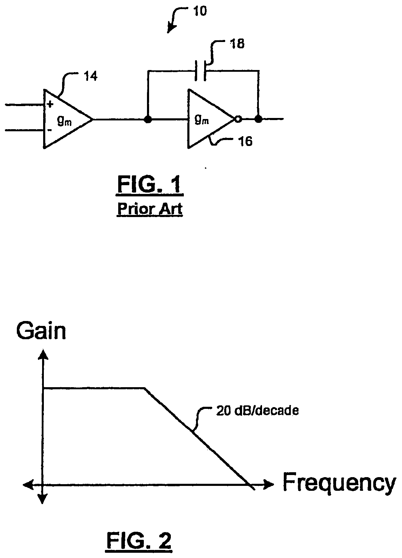

Referring now to FIGs. 1 and 2, an amplifier circuit 10 with Miller compensation is shown and includes first and second amplifiers 14 and 16, respectively. An output of the first amplifier 14 communicates with an input of the second amplifier 16. A first end of a Miller capacitance 18 communicates with the input of the second amplifier 16 and a second end of the Miller capacitance 18 communicates with the output of the second amplifier 16.

An input voltage of the amplifier circuit 10 is applied to an input of the first amplifier 14. An output voltage of the amplifier circuit 10 Is referenced from the output of the second amplifier 16. As a result of the Miller compensation, the transconductance, gₘ, of the second amplifier 16 may be increased, which increases the bandwidth of the amplifier circuit 10. As can be seen in FIG. 2, the gain of the amplifier with Miller compensation has a 20 dB/decade slope.

Amplifiers may also be used with switched capacitive Input signals. The switched capacitive input signals may be generated in analog to digital converters (ADCs), digital to analog converters (DACs), filters and/or other circuits. Traditional amplifiers such as those shown in FIG. 1 tend to have a difficult time providing sufficient gain and bandwidth at acceptable noise levels, particularly for switched capacitive input signals.

US-A-5 990 748 discloses an operational amplifier that is frequency self-compensated with respect to the closed-loop gain. The amplifier comprises a transconductance input stage and an amplifier output stage, serially connected together. Provided between the input and output stages is an intermediate node, which is connected to a compensation block to receive a frequency variable compensation signal therefrom. The compensation block is internal to the operational circuit and is used for closed-loop frequency compensation.

It is the object of the present invention to provide an improved amplifier circuit.

This object is solved by the subject matter of the independent claims.

Preferred embodiments are defined by the dependent claims.

An amplifier circuit comprises a first amplifier having an input and an output. A second operational transconductance amplifier (OTA) has an input connected to the output of the first amplifier. A third amplifier has an input connected to the input of the first amplifier and an output.
A fourth OTA has an input connected to the output of the third amplifier and an output. A feedback resistance connected to the input and the output of the fourth OTA. A capacitance connected to the output of the fourth OTA and with the input of the second OTA.

In other features, N OTAs are connected in series, wherein N is an integer greater than zero. An input of a first of the N OTAs connected to the output the first amplifier and output of a last one of the N OTAs connected to the input of the second OTA. The input of the third amplifier is capacitively coupled to the first amplifier. A switched capacitance circuit selectively connected to of the input and the output of the third amplifier.

In other features, the switched capacitance circuit comprises a first switch having a first terminal connected to the input of the third amplifier. A second switch has a first terminal connected to the output the third amplifier. A capacitance has one end connected to second terminals of the first and second switches.

A digital to analog converter comprises the amplifier circuit and further comprises a circuit that generates a switched capacitance input signal that is input to the input of the amplifier circuit. An analog to digital converter comprises the amplifier circuit and further comprises a circuit that generates a switched capacitance input signal that is input to the input of the amplifier circuit. A filter comprises the amplifier circuit and further comprises a circuit that generates a switched capacitance input signal that is input to the input of the amplifier circuit.

The amplifier circuit comprises a switched capacitance circuit selectively couples a capacitance to at least one of the input of the third OTA and the output of third OTA.

In other features, the switched capacitance circuit comprises: a first switch having a first terminal connected to the input of the third OTA; a second switch having a first terminal connected to the output the third OTA; and a capacitance having one end connected to second terminals of the first and second switches.

In other features, a capacitance has one end connected to the input of the first OTA and an opposite end connected to the output of the second OTA. N additional OTAs connected in series between the output of the first OTA and the input of the second OTA.

A digital to analog converter comprises the amplifier circuit and further comprises a circuit that generates a switched capacitance input signal that is input to the input of the first OTA. An analog to digital converter comprises the amplifier circuit and further comprises a circuit that generates a switched capacitance input signal that is input to the input of the first OTA. A filter comprises the amplifier circuit and further comprises a circuit that generates a switched capacitance input signal that is input to the input of the first OTA. The switched capacitance input signal includes first and second phases and wherein switches in the switched capacitance circuit are switched based on the first and second phases of the switched capacitance input signal.

A digital to analog converter comprises the amplifier circuit and further comprises means for generating a switched capacitance input signal that is input to the input of the first transconductance means. An analog to digital converter comprises the amplifier circuit and further comprises means for generating a switched capacitance input signal that Is input to the input of the first transconductance means. A filter comprises the amplifier circuit and further comprises means for generating a switched capacitance input signal that is input to the input of the first transconductance means. The switched capacitance input signal includes first and second phases. The first and second switching means in the switched capacitance means are switched based on the first and second phases of the switched capacitance input signal. The amplifier circuit is configured in a differential mode.

Further areas of applicability of the present invention will become apparent from the detailed description provided hereinafter. It should be understood that the detailed description and specific examples, while indicating the preferred embodiment of the invention, are intended for purposes of illustration only and are not intended to limit the scope of the invention.

### BRIEF DESCRIPTION OF THE DRAWINGS

The present invention will become more fully understood from the detailed description and the accompanying drawings, wherein:
FIG. 1 is an electrical schematic of an amplifier with Miller compensation according to the prior art;
FIG. 2 is a graph Illustrating gain and bandwidth for the amplifier of FIG. 1;
FIG. 3A is an electrical schematic of an exemplary amplifier with compensation according to the present invention;
FIG. 3B is an electrical schematic of an exemplary amplifier with compensation according to the present invention;
FIG. 3C is an electrical schematic of an exemplary amplifier with compensation according to the present invention;
FIG. 3D is an electrical schematic of an exemplary amplifier with compensation according to the present invention;
FIGs. 4A-4C are graphs illustrating exemplary gain and bandwidth for the amplifiers;
FIGs. 5 and 6 are electrical schematics of amplifiers with compensation and additional gain stages according to the present invention;
FIG. 7A is an electrical schematic of an exemplary amplifier according to the present invention;
FIG. 7B is an electrical schematic of the amplifier of FIG. 7A with parasitic capacitance;
FIG. 7C is an electrical schematic of an amplifier according to the present Invention with a switched capacitance circuit;
FIG. 8 is a functional block diagram illustrating an exemplary switched input comprising a switched capacitance circuit and the amplifier of FIG. 7C;
FIG. 9 is a functional block diagram and electrical schematic illustrating an exemplary switched capacitance circuit;
FIG. 10 is an electrical schematic of the amplifier of FIG. 7C with additional amplifier stages;
FIG. 11 is electrical schematic of the amplifier of FIG. 7C configured in a differential mode;
FIG. 12A is a functional block diagram of a hard disk drive;
FIG. 12B is a functional block diagram of a digital versatile disk (DVD);
FIG. 12C is a functional block diagram of a high definition television;
FIG. 12D is a functional block diagram of a vehicle control system;
FIG. 12E is a functional block diagram of a cellular phone;
FIG. 12F is a functional block diagram of a set top box; and
FIG. 12G is a functional block diagram of a media player.

### DETAILED DESCRIPTION OF THE PREFERRED EMBODIMENTS

The following description of the preferred embodiment(s) is merely exemplary in nature and is in no way intended to limit the invention, its application, or uses. As used herein, the term module, circuit and/or device refers to an Application Specific Integrated Circuit (ASIC), an electronic circuit, a processor (shared, dedicated, or group) and memory that execute one or more software or firmware programs, a combinational logic circuit, and/or other suitable components that provide the described functionality. As used herein, the phrase at least one of A, B, and C should be construed to mean a logical (A or B or C), using a non-exclusive logical or. It should be understood that steps within a method may be executed in different order without altering the principles of the present invention. For purposes of clarity, the same reference numbers will be used in the drawings to identify similar elements.

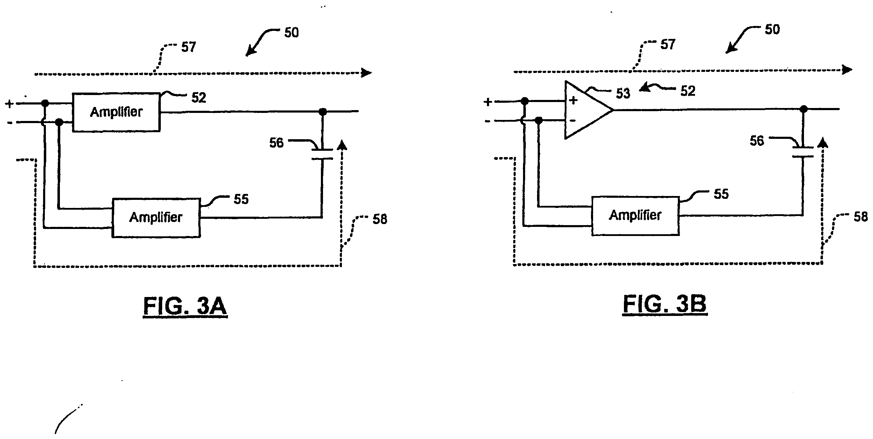

Referring now to FIG. 3A, an electrical schematic of an amplifier circuit 50 with compensation according to the present invention is shown. While specific examples of amplifier circuits will be shown and described, other combinations are contemplated. The amplifier circuit 50 includes a first amplifier module 52 having an input and an output. The inputs of the amplifier module 52 communicate with inputs of an amplifier module 55. Outputs of the amplifier module 55 are coupled by a capacitor 56 to the output of the amplifier module 52.

The amplifier module 55 may have a gain that is less than the gain of the amplifier module 52. The amplifier module 52 may have a gain that is greater than or equal to 100. The amplifier module 55 may have a gain that is less than 100. In some implementations, the gain of the amplifier module 55 is substantially less than 100. The amplifier module 55 may have a very high bandwidth and a low output impedance. The amplifier module 55 may have a bandwidth that is greater than a bandwidth of the amplifier module 52. The output impedance of the amplifier module 52 may be greater than the output impedance of the amplifier module 55. The amplifier module 55 includes a transimpedance amplifier. The amplifier circuit 50 has a first DC path 57 and a second high frequency path 58.

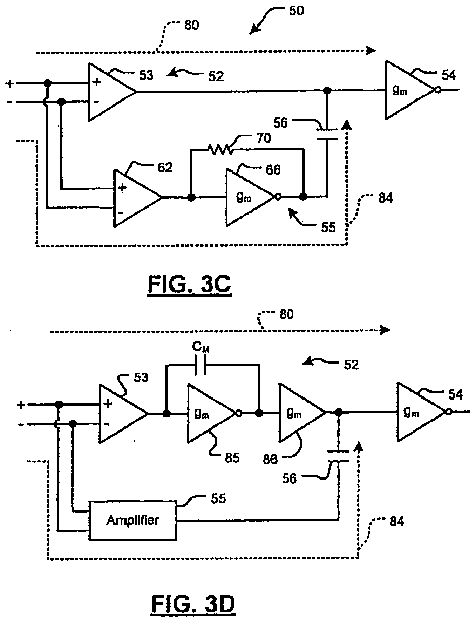

Referring now to FIG. 3B-3D, various combinations of amplifiers can be used in the amplifier modules 52 and 55 of the amplifier circuit 50. While specific examples will be shown, other combinations are contemplated. In FIG. 3B, the amplifier module 52 may include an amplifier 53. In FIG. 3C, the amplifier module 55 may include a transimpedance amplifier. In FIG. 3D, the amplifier module 52 may include a Miller compensated amplifier. Still other variations are contemplated.

Referring back to FIG. 3C, the amplifier circuit 50, which includes the amplifier module 52 that includes a first amplifier 53 having an output that communicates with an input of a second amplifier 54. Inputs of the amplifier 53 are coupled to the amplifier module 55. The amplifier module 55 includes an amplifier 62, an amplifier 66 and a feedback resistance 70. An output of the amplifier 62 is coupled to an input of the amplifier 66. The feedback resistance 70 is connected between the input of the amplifier 66 and an output of the amplifier 66. A capacitance element 56 capacitively couples the output of the amplifier 66 to the input of the amplifier 54. The amplifiers 53 and 54 provide a DC gain path 80. Gain of the DC gain path 80 can be adjusted using additional amplifiers. The amplifiers 62 and 66 and the capacitance 56 provide a highfrequency gain path 84.

Referring now to FIG. 3D, the amplifier module 52 may include the amplifier 53 and a Miller compensated amplifier 85 with capacitive feedback C_{M}. An additional amplifier 86 may be provided between the output of the Miller compensated amplifier 85 and the input of the amplifier 54. Still other combinations are contemplated.

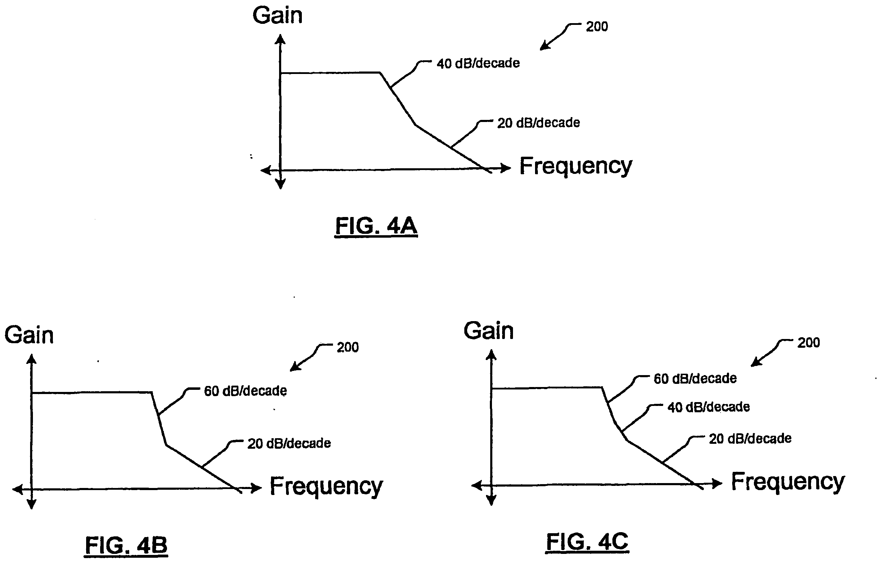

Referring now to FIG. 4A-4C, exemplary graphs illustrating gain and bandwidth for the amplifier circuits are shown. As can be appreciated, the amplifier circuit 50 in FIG. 3A has additional bandwidth at higher gain values. A slope of the gain is increased to 40 dB/decade such that the gain falls off later but more quickly. Additional gain stages may further Increase the slope to 60 dB/decade as shown in FIG. 4B. Depending upon the stages and/or configuration, regions of the gain-bandwidth response may have a slope of 20, 40, 60, etc dB/decade as shown in FIG. 4C.

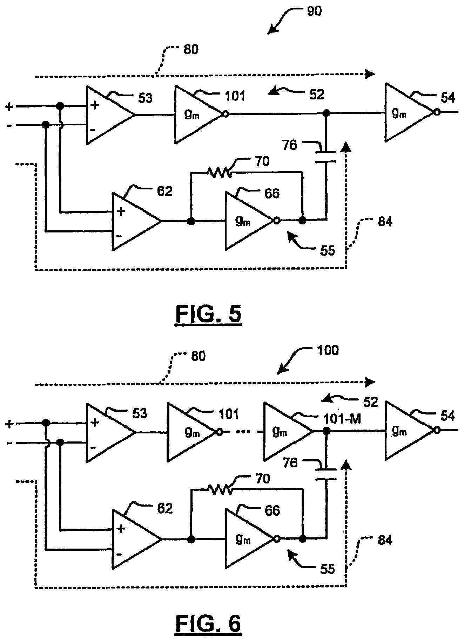

Referring now to FIGs. 5 and 6, electrical schematics of other amplifiers with compensation and additional gain are shown. One or more additional amplifiers may be provided in the DC gain path 80 to provide additional gain. In FIG. 5, an amplifier circuit 90 includes amplifiers 53 and 101 that are connected between the input of the amplifier 90 and the amplifier 54. In FIG. 6, an amplifier circuit 100 includes one or more additional amplifiers 101-M that are connected between amplifiers 52-2 and 54, where M is an integer greater than one. As can be appreciated, additional amplifier stages may be added to the DC path to provide additional gain as needed.

The amplifier circuits according to the present invention have improved gain at both high and low frequency and improved settling time. The amplifier circuits have high gain while operating at low voltage because each stage can now be configured in a non-cascode arrangement.

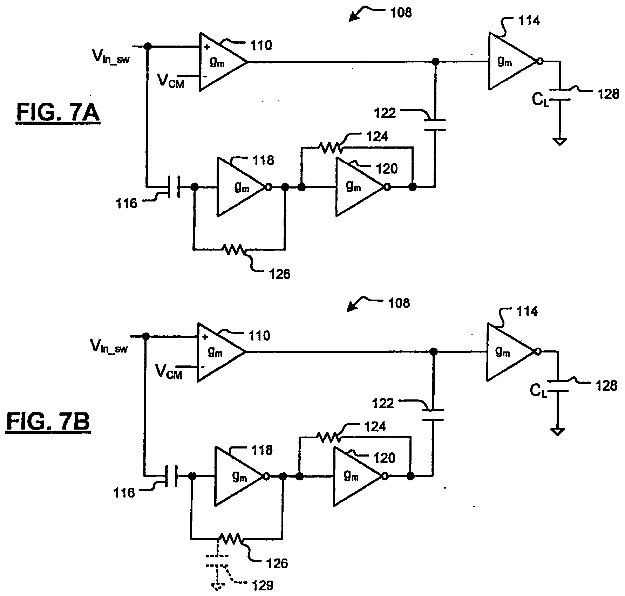

Referring now to FIGs. 7A and 7B, an amplifier circuit 108 includes an amplifier 110 having an input and an output that is coupled to an input of an amplifier 114. The input of the amplifier 110 is coupled by a capacitance 116 to an input of an amplifier 118. An output of the amplifier 118 is coupled to an input of the amplifier 120. An output of the amplifier 120 is coupled by a capacitance 122 to the input of the amplifier 114.

A feedback resistance 124 is connected to the input and output of the amplifier 120. A feedback resistance 126 is connected to the input and output of the amplifier 118. The feedback resistance 126 may have a high resistance value. For example, the feedback resistance may have a resistance value that is greater than a resistance value of the resistance 124. The feedback resistance 126 may have a very high resistance, for example a resistance approaching infinity. A load capacitance 128 may be connected to an output of the amplifier 114. In FIG. 7B, parasitic capacitance 129 associated with the relatively high feedback resistance 126 may tend to limit bandwidth of the circuit.

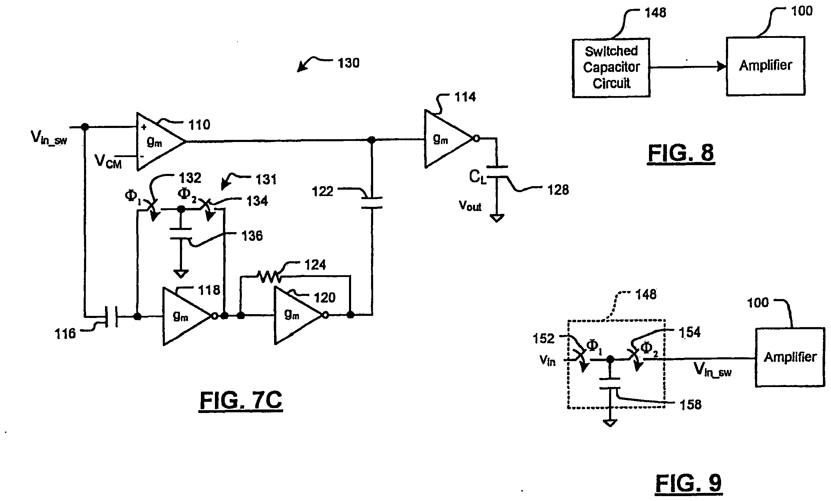

In FIG. 7C, an amplifier circuit 130 according to the present invention is shown. The amplifier circuit 130 may include a switched capacitance to simulate the high feedback resistance 126 without the problems associated with parasitic capacitance. The amplifier circuit 130 Includes an amplifier 110 having an output that is coupled to an input of an amplifier 114. An input of the amplifier 110 is also coupled by a capacitance 116 to an input of an amplifier 118. An output of the amplifier 118 is coupled to an input of the amplifier 120. An output of the amplifier 120 is coupled by a capacitance 122 to the input of the amplifier 114.

The input and output of the amplifier 118 may communicate with a switched capacitance circuit 131. The switched capacitance circuit 131 includes first and second switches 132 and 134. A capacitance 136 is connected between the switches 132 and 134 and a reference potential such as ground. During a first phase Φ₁, the first switch 132 is closed and the second switch 134 is open and the capacitance 136 is charged. During a second phase Φ₂, the first switch 132 is open and the second switch 134 is closed, which allows the capacitance 136 to discharge. The first and second phases may correspond to the first and second phases of the switched input and/or vice versa. A feedback resistor 124 is connected to the input and output of the amplifier 120. A load capacitance 146 may be connected to an output of the amplifier 114. In some applications, the amplifier 130 may receive a switched input. The switched Input may be a switched capacitive input such as that found in capacitive ADCs, DACs, filters and the like.

Referring now to FIGs. 8 and 9, an exemplary circuit comprising a switched capacitance circuit 148 and the amplifier 130 of FIG. 7C are shown. An input voltage to the amplifier circuit 130 may be a switched capacitance input. Switched capacitance inputs may be generated in circuits such as filters, digital to analog converters (DAC), analog to digital converters (ADC) and other circuits. As can be appreciated, other types of input and/or other switched capacitance circuits may be used. The switched capacitance circuit 148 includes first and second switches 152 and 154. A capacitance 158 is connected between the switches 152 and 154 and a reference potential such as ground. During a first phase Φ₁, the first switch 152 is closed and the second switch 154 is open and the capacitance 158 is charged. During a second phase Φ₂, the first switch 152 is open and a second switch 154 is closed and the capacitance 158 discharges via the amplifier 100.

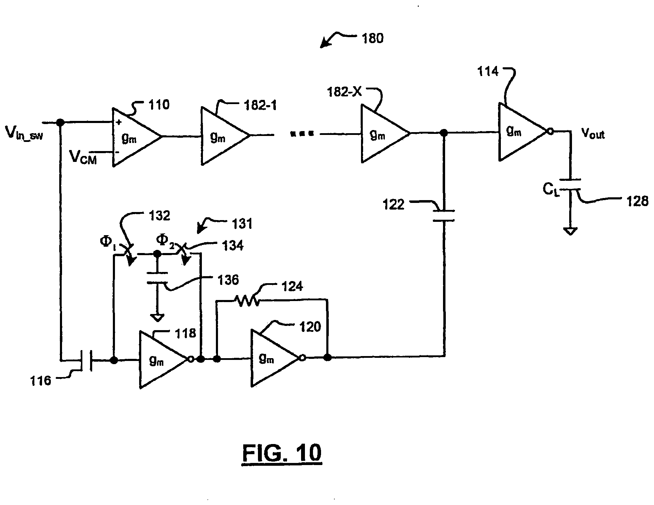

Referring now to FIG. 10, an amplifier circuit 180 is similar to that shown in FIG 7C and further includes amplifiers 182-1, 182-2, ... 182-X, where X is an integer greater than zero. The additional amplifiers 182 tend to increase the slope of the gain-bandwidth response In a region 200 shown in FIG. 4.

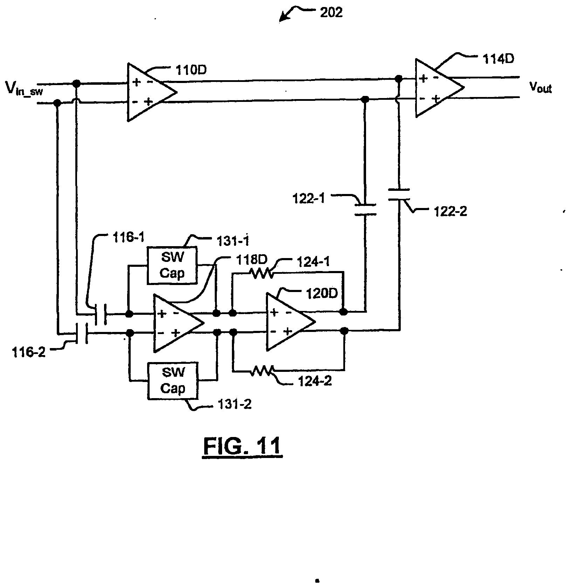

Any of the amplifier circuits described above can be configured in a differential mode. For example and referring now to FIG. 11, the amplifier of FIG. 7C can be configured in a differential mode. Other amplifiers described herein may be configured in a differential mode as well. An amplifier 202 according to the present invention that receives a differential switched input is shown. The amplifier 202 includes a differential amplifier 110D having differential outputs that are coupled to differential inputs of a differential amplifier 114D. Differential inputs of the differential amplifier 110D are also coupled by capacitances 116-1 and 116-2 to differential inputs of a differential amplifier 118D. Differential outputs of the differential amplifier 118D are coupled to differential inputs of the differential amplifier 120D. Differential outputs of the differential amplifier 120D are coupled by capacitances 122-1 and 122-2 to the differential inputs of the differential amplifier 114D.

The differential inputs and differential outputs of the differential amplifier 118D communicate with switched capacitance circuits 131-1 and 131-2. Load capacitances (not shown) may be connected to differential outputs of the differential amplifier 114D.

The amplifiers described herein may be amplifiers, operational amplifiers, operational transconductance amplifiers (OTAs), amplifiers with Miller compensation and/or other suitable amplifiers. The OTA is a transconductance type device. The input voltage controls an output current based on the transconductance gₘ. In other words, the OTA is a voltage-controlled current source (VCCS), which is in contrast to the conventional amplifier (opamp), which is a voltage-controlled voltage source (VCVS).

The transconductance parameter of the OTA is controlled by an amplifier bias current. From this controlled transconductance, the output current is a function of the applied voltage difference between the input pins. There are two key differences between the OTA and the conventional opamp. First, since the OTA is a current source, the output impedance of the device Is high. In contrast, the output impedance of the opamp is very low. Second, It is possible to design circuits using the OTA that do not employ negative feedback. In other words, instead of employing feedback to reduce the sensitivity of a circuit's performance to device parameters.

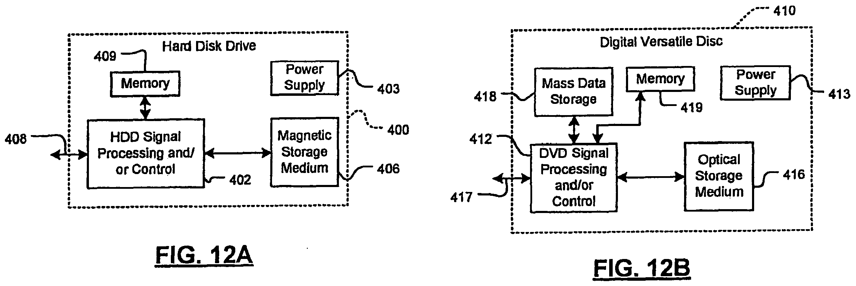

Referring now to FIGs. 12A-12G, various exemplary implementations of the present invention are shown. Referring now to FIG. 12A, the present invention can be implemented amplifiers, ADC, DAC, filters and other circuits in a hard disk drive 400. In some implementations, the signal processing and/or control circuit 402 and/or other circuits (not shown) in the HDD 400 may process data, perform coding and/or encryption, perform calculations, and/or format data that is output to and/or received from a magnetic storage medium 406.

The HDD 400 may communicate with a host device (not shown) such as a computer, mobile computing devices such as personal digital assistants, cellular phones, media or MP3 players and the like, and/or other devices via one or more wired or wireless communication links 408. The HDD 400 may be connected to memory 409 such as random access memory (RAM), low latency nonvolatile memory such as flash memory, read only memory (ROM) and/or other suitable electronic data storage.

Referring now to FIG. 12B, the present invention can be implemented in amplifiers, ADC, DAC, filters and other circuits of a digital versatile disc (DVD) drive 410. The signal processing and/or control circuit 412 and/or other circuits (not shown) In the DVD 410 may process data, perform coding and/or encryption, perform calculations, and/or format data that is read from and/or data written to an optical storage medium 416. In some implementations, the signal processing and/or control circuit 412 and/or other circuits (not shown) in the DVD 410 can also perform other functions such as encoding and/or decoding and/or any other signal processing functions associated with a DVD drive.

The DVD drive 410 may communicate with an output device (not shown) such as a computer, television or other device via one or more wired or wireless communication links 417. The DVD 410 may communicate with mass data storage 418 that stores data in a nonvolatile manner. The mass data storage 418 may include a hard disk drive (HDD). The HDD may have the configuration shown in FIG. 12A. The HDD may be a mini HDD that includes one or more platters having a diameter that is smaller than approximately 1.8". The DVD 410 may be connected to memory 419 such as RAM, ROM, low latency nonvolatile memory such as flash memory and/or other suitable electronic data storage.

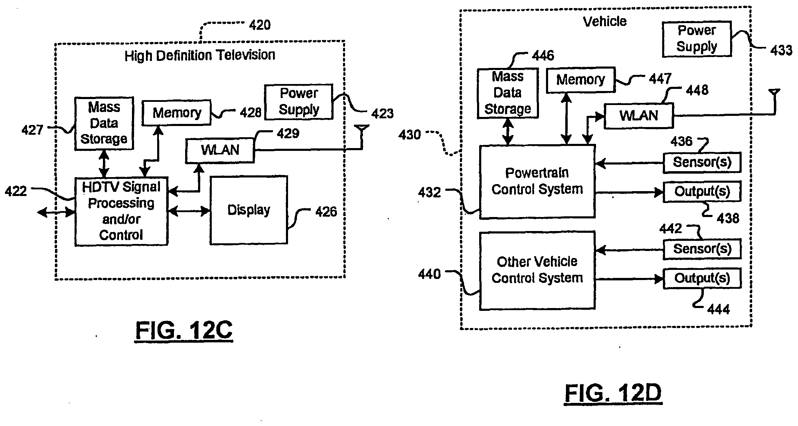

Referring now to FIG. 12C, the present invention can be implemented in amplifiers, ADC, DAC, filters and other circuits of a high definition television (HDTV) 420. The HDTV 420 receives HDTV input signals in either a wired or wireless format and generates HDTV output signals for a display 426. In some implementations, signal processing circuit and/or control circuit 422 and/or other circuits (not shown) of the HDTV 420 may process data, perform coding and/or encryption, perform calculations, format data and/or perform any other type of HDTV processing that may be required.

The HDTV 420 may communicate with mass data storage 427 that stores data in a nonvolatile manner such as optical and/or magnetic storage devices. At least one HDD may have the configuration shown in FIG. 12A and/or at least one DVD may have the configuration shown in FIG. 12B. The HDD may be a mini HDD that includes one or more platters having a diameter that is smaller than approximately 1.8". The HDTV 420 may be connected to memory 428 such as RAM, ROM, low latency nonvolatile memory such as flash memory and/or other suitable electronic data storage. The HDTV 420 also may support connections with a WLAN via a WLAN network interface 429.

Referring now to FIG. 12D, the present Invention may implement and/or be implemented in amplifiers, ADC, DAC, filters and other circuits of a control system of a vehicle 430, a WLAN interface, mass data storage of the vehicle control system and/or a power supply 433. In some implementations, the present invention implement a powertrain control system 432 that receives inputs from one or more sensors such as temperature sensors, pressure sensors, rotational sensors, airflow sensors and/or any other suitable sensors and/or that generates one or more output control signals such as engine operating parameters, transmission operating parameters, and/or other control signals.

The present invention may also be implemented in other control systems 440 of the vehicle 430. The control system 440 may likewise receive signals from input sensors 442 and/or output control signals to one or more output devices 444. In some implementations, the control system 440 may be part of an anti-lock braking system (ABS), a navigation system, a telematics system, a vehicle telematics system, a lane departure system, an adaptive cruise control system, a vehicle entertainment system such as a stereo, DVD, compact disc and the like. Still other implementations are contemplated.

The powertrain control system 432 may communicate with mass data storage 446 that stores data in a nonvolatile manner. The mass data storage 446 may include optical and/or magnetic storage devices for example hard disk drives HDD and/or DVDs. At least one HDD may have the configuration shown in FIG. 12A and/or at least one DVD may have the configuration shown in FIG. 12B. The HDD may be a mini HDD that includes one or more platters having a diameter that is smaller than approximately 1.8". The powertrain control system 432 may be connected to memory 447 such as RAM, ROM, low latency nonvolatile memory such as flash memory and/or other suitable electronic data storage. The powertrain control system 432 also may support connections with a WLAN via a WLAN network interface 448. The control system 440 may also include mass data storage, memory and/or a WLAN interface (all not shown).

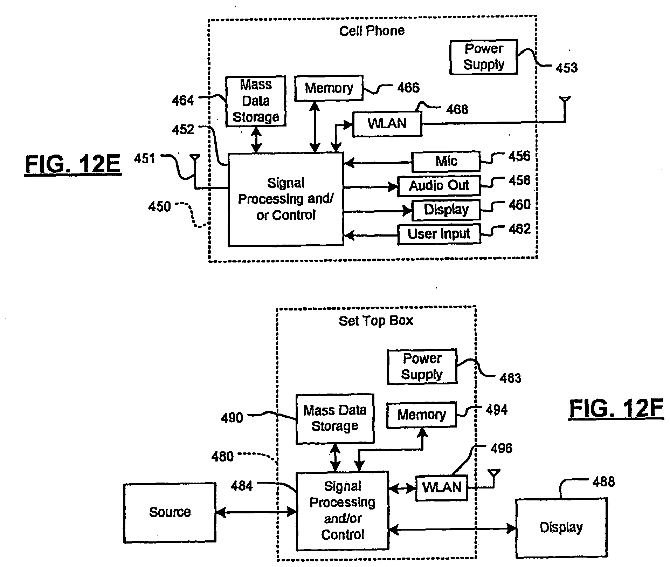

Referring now to FIG. 12E, the present invention can be implemented in amplifiers, ADC, DAC, filters and other circuits of a cellular phone 450 that may include a cellular antenna 451. In some implementations, the cellular phone 450 includes a microphone 456, an audio output 458 such as a speaker and/or audio output jack, a display 460 and/or an input device 462 such as a keypad, pointing device, voice actuation and/or other input device. The signal processing and/or control circuits 452 and/or other circuits (not shown) in the cellular phone 450 may process data, perform coding and/or encryption, perform calculations, format data and/or perform other cellular phone functions.

The cellular phone 450 may communicate with mass data storage 464 that stores data in a nonvolatile manner such as optical and/or magnetic storage devices for example hard disk drives HDD and/or DVDs. At least one HDD may have the configuration shown in FIG. 12A and/or at least one DVD may have the configuration shown in FIG. 12B. The HDD may be a mini HDD that includes one or more platters having a diameter that is smaller than approximately 1.8". The cellular phone 450 may be connected to memory 466 such as RAM, ROM, low latency nonvolatile memory such as flash memory and/or other suitable electronic data storage. The cellular phone 450 also may support connections with a WLAN via a WLAN network interface 468.

Referring now to FIG. 12F, the present invention can be implemented in amplifiers, ADC, DAC, filters and other circuits of a set top box 480. The set top box 480 receives signals from a source such as a broadband source and outputs standard and/or high definition audio/video signals suitable for a display 488 such as a television and/or monitor and/or other video and/or audio output devices. The signal processing and/or control circuits 484 and/or other circuits (not shown) of the set top box 480 may process data, perform coding and/or encryption, perform calculations, format data and/or perform any other set top box function.

The set top box 480 may communicate with mass data storage 490 that stores data in a nonvolatile manner. The mass data storage 490 may include optical and/or magnetic storage devices for example hard disk drives HDD and/or DVDs. At least one HDD may have the configuration shown in FIG. 12A and/or at least one DVD may have the configuration shown in FIG. 12B. The HDD may be a mini HDD that includes one or more platters having a diameter that is smaller than approximately 1.8". The set top box 480 may be connected to memory 4124 such as RAM, ROM, low latency nonvolatile memory such as flash memory and/or other suitable electronic data storage. The set top box 480 also may support connections with a WLAN via a WLAN network interface 4126.

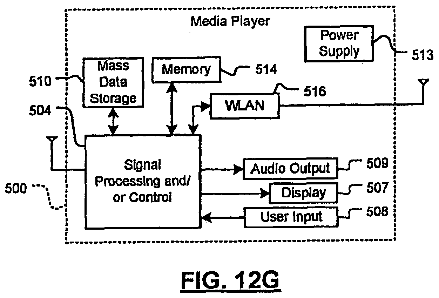

Referring now to FIG. 12G, the present invention can be implemented in amplifiers, ADC, DAC, filters and other circuits of a media player 500. In some implementations, the media player 500 includes a display 507 and/or a user input 508 such as a keypad, touchpad and the like. In some implementations, the media player 500 may employ a graphical user interface (GUI) that typically employs menus, drop down menus, icons and/or a point-and-click interface via the display 507 and/or user input 508. The media player 500 further includes an audio output 509 such as a speaker and/or audio output jack. The signal processing and/or control circuits 504 and/or other circuits (not shown) of the media player 500 may process data, perform coding and/or encryption, perform calculations, format data and/or perform any other media player function.

The media player 500 may communicate with mass data storage 510 that stores data such as compressed audio and/or video content in a nonvolatile manner. In some implementations, the compressed audio files include files that are compliant with MP3 format or other suitable compressed audio and/or video formats. The mass data storage may include optical and/or magnetic storage devices for example hard disk drives HDD and/or DVDs. At least one HDD may have the configuration shown in FIG. 12A and/or at least one DVD may have the configuration shown in FIG. 12B. The HDD may be a mini HDD that includes one or more platters having a diameter that is smaller than approximately 1.8". The media player 500 may be connected to memory 514 such as RAM, ROM, low latency nonvolatile memory such as flash memory and/or other suitable electronic data storage. The media player 500 also may support connections with a WLAN via a WLAN network interface 516. Still other implementations in addition to those described above are contemplated.

Those skilled in the art can now appreciate from the foregoing description that the broad teachings of the present invention can be implemented in a variety of forms. Therefore, while this invention has been described in connection with particular examples thereof, the scope of the invention should not be so limited since other modifications will become apparent to the skilled practitioner upon a study of the drawings, the specification and the following claims.

Thus, the scope of the invention is only limited by the appended claims.

## Claims

1. An amplifier circuit for amplifying switched capacitive input signals, comprising:
a first amplifier (53) having an input and an output, said input being for receiving a switched capacitive input signal;
a second operational transconductance amplifier, OTA, (54) having an input connected to said output of said first amplifier;
a third amplifier (62) having an input connected to said input of said first amplifier and an output;
a fourth OTA (66) having an input connected to said output of said third amplifier and an output;
a feedback resistor (70) connected between said input and said output of said fourth OTA; and
a capacitor (56) connected to said output of said fourth OTA and to said input of said second OTA.

2. The amplifier circuit of Claim 1 further comprising N OTAs (101 - 101M) connected in series, wherein N is an integer greater than zero and wherein an input of a first of said N OTAs is connected to said output said first amplifier and output of a last one of said N OTAs is connected to said input of said second OTA.

3. The amplifier circuit of Claim 1 wherein said input of said third amplifier is capacitively coupled to said first amplifier and further comprising a switched capacitance circuit (131) that selectively connects to said input and said output of said third amplifier.

4. The amplifier circuit of Claim 3 wherein said switched capacitance circuit comprises:
a first switch (132) having a first terminal connected to said input of said third amplifier;
a second switch (134) having a first terminal connected to said output said third amplifier; and
a capacitor (136) having one end connected to second terminals of said first and second switches.

5. A digital to analog converter comprising the amplifier circuit of Claim 3 and further comprising a circuit that generates a switched capacitance input signal that is input to said input of said amplifier circuit.

6. An analog to digital converter comprising the amplifier circuit of Claim 3 and further comprising a circuit that generates a switched capacitance input signal that is input to said input of said amplifier circuit.

7. A filter comprising the amplifier circuit of Claim 3 and further comprising a circuit that generates a switched capacitance input signal that is input to said input of said amplifier circuit.

8. The amplifier circuit of claim 1, further comprising: a switched capacitance circuit (131) that selectively couples a capacitor to at least one of said input of said third OTA and said output of third OTA.

9. The amplifier circuit of Claim 8 wherein said switched capacitance circuit comprises:
a first switch (132) having a first terminal connected to said input of said third OTA;
a second switch (134) having a first terminal connected to said output said third OTA; and
a capacitor (136) having one end connected to second terminals of said first and second switches.

10. The amplifier circuit of Claim 8 further comprising a capacitor having one end connected to said input of said first OTA and an opposite end connected to said output of said second OTA.

11. The amplifier circuit of Claim 8 further comprising N additional OTAs (182-1-182-X) connected in series between said output of said first OTA and said input of said second OTA.

12. A digital to analog converter comprising the amplifier circuit of Claim 8 and further comprising a circuit that generates a switched capacitance input signal that is input to said input of said first OTA.

13. An analog to digital converter comprising the amplifier circuit of Claim 8 and further comprising a circuit that generates a switched capacitance input signal that is input to said input of said first OTA.

14. A filter comprising the amplifier circuit of Claim 8 and further comprising a circuit that generates a switched capacitance input signal that is input to said input of said first OTA.

15. The digital to analog converter of Claim 12 wherein said switched capacitance input signal includes first and second phases and wherein switches in said switched capacitance circuit are switched based on said first and second phases of said switched capacitance input signal.

16. The analog to digital converter of Claim 13 wherein said switched capacitance input signal includes first and second phases and wherein switches in said switched capacitance circuit are switched based on said first and second phases of said switched capacitance input signal.

17. The filter of Claim 14 wherein said switched capacitance input signal includes first and second phases and wherein switches in said switched capacitance circuit are switched based on said first and second phases of said switched capacitance input signal.

18. The amplifier circuit of Claim 8 wherein said amplifier circuit is configured in a differential mode.

19. The amplifier circuit of Claim 8 further comprising a capacitor having one end connected to said input of said first OTA and an opposite end connected to said input of said third OTA.

## Patentansprüche

1. Verstärkerschaltung zum Verstärken von geschalteten kapazitiven Eingangssignalen, umfassend:
einen ersten Verstärker (53) mit einem Eingang und einem Ausgang, wobei der Eingang zum Aufnehmen eines geschalteten kapazitiven Eingangssignals dient;
einen zweiten Transkonduktanz-Operationsverstärker, OTA, (54) dessen Eingang mit dem Ausgang des ersten Verstärkers verbunden ist,
einen dritten Verstärker (62) mit einem Eingang, der mit dem Eingang des ersten Verstärkers verbunden ist, und einem Eingang;
einen dritten OTA (66) mit einem Eingang, der mit dem Ausgang des dritten Verstärkers verbunden ist, und einem Eingang;
einen Rückkopplungswiderstand (70), der zwischen dem Eingang und dem Ausgang des vierten OTA angeschlossen ist; und
einen Kondensator (56), der mit dem Ausgang des vierten OTA und dem Eingang des zweiten OTA verbunden ist.

2. Verstärkerschaltung nach Anspruch 1, des Weiteren umfassend N OTAs (101 - 101M), die in Reihe geschaltet sind, wobei N eine ganze Zahl größer null ist, und wobei ein Eingang des ersten der N OTAs mit dem Ausgang des ersten Verstärker verbunden ist und der Ausgang eines letzten der N OTAs mit dem Eingang des zweiten OTA verbunden ist.

3. Verstärkerschaltung nach Anspruch 1, wobei der Eingang des dritten Verstärkers kapazitiv mit dem ersten Verstärker gekoppelt ist, und des Weiteren umfassend eine geschaltete Kapazitätsschaltung (131), die selektiv eine Verbindung zu dem Eingang und dem Ausgang des dritten Verstärkers herstellt.

4. Verstärkerschaltung nach Anspruch 3, wobei die geschaltete Kapazitätsschaltung umfasst:
einen ersten Schalter (132) mit einem ersten Anschluss, der mit dem Eingang des dritten Verstärkers verbunden ist;
einen zweiten Schalter (134) mit einem ersten Anschluss, der mit dem Ausgang des dritten Verstärkers verbunden ist; und
einen Kondensator (136) mit einem Ende, das mit den zweiten Anschlüssen des ersten und zweiten Schalters verbunden ist.

5. Digital-Analog-Wandler, umfassend die Verstärkerschaltung nach Anspruch 3 und des Weiteren umfassend eine Schaltung, die ein geschaltetes Kapazitätseingangssignal erzeugt, das in den Eingang der Verstärkerschaltung eingegeben wird.

6. Analog-Digital-Wandler, umfassend die Verstärkerschaltung nach Anspruch 3 und des Weiteren umfassend eine Schaltung, die ein geschaltetes Kapazitätseingangssignal erzeugt, das in den Eingang der Verstärkerschaltung eingegeben wird.

7. Filter, umfassend die Verstärkerschaltung nach Anspruch 3 und des Weiteren umfassend eine Schaltung, die ein geschaltetes Kapazitätseingangssignal erzeugt, das in den Eingang der Verstärkerschaltung eingegeben wird.

8. Verstärkerschaltung nach Anspruch 1, des Weiteren umfassend:
eine geschaltete Kapazitätsschaltung (131), die selektiv einen Kondensator mit mindestens einem aus dem Eingang des dritten OTA und den Ausgang des dritten OTA verbindet.

9. Verstärkerschaltung nach Anspruch 8, wobei die geschaltete Kapazitätsschaltung umfasst:
einen ersten Schalter (132) mit einem ersten Anschluss, der mit dem Eingang des dritten OTA verbunden ist;
einen zweiten Schalter (134) mit einem ersten Anschluss, der mit dem Ausgang des dritten OTA verbunden ist; und
einen Kondensator (136) mit einem Ende, das mit den zweiten Anschlüssen des ersten und zweiten Schalters verbunden ist.

10. Verstärkerschaltung nach Anspruch 8, des Weiteren umfassend einen Kondensator mit einem Ende, das mit dem Eingang des ersten OTA verbunden ist, und einem gegenüberliegenden Ende, das mit dem Ausgang des zweiten OTA verbunden ist.

11. Verstärkerschaltung nach Anspruch 8, des Weiteren umfassend N zusätzliche OTAs (182-1-182-X), die zwischen dem Ausgang des ersten OTA und dem Eingang des zweiten OTA in Reihe geschaltet sind.

12. Digital-Analog-Wandler, umfassend die Verstärkerschaltung nach Anspruch 8 und des Weiteren umfassend eine Schaltung, die ein geschaltetes Kapazitätseingangssignal erzeugt, das in den Eingang des ersten OTA eingegeben wird.

13. Analog-Digital-Wandler, umfassend die Verstärkerschaltung nach Anspruch 8 und des Weiteren umfassend eine Schaltung, die ein geschaltetes Kapazitätseingangssignal erzeugt, das in den Eingang des ersten OTA eingegeben wird.

14. Filter, umfassend die Verstärkerschaltung nach Anspruch 8 und des Weiteren umfassend eine Schaltung, die ein geschaltetes Kapazitätseingangssignal erzeugt, das in den Eingang des ersten OTA eingegeben wird.

15. Digital-Analog-Wandler nach Anspruch 12, wobei das geschaltete Kapazitätseingangssignal eine erste und eine zweite Phase beinhaltet, und wobei Schalter in der geschalteten Kapazitätsschaltung basierend auf der ersten und zweiten Phase des geschalteten Kapazitätseingangssignals geschaltet werden.

16. Analog-Digital-Wandler nach Anspruch 13, wobei das geschaltete Kapazitätseingangssignal eine erste und eine zweite Phase beinhaltet, und wobei Schalter in der geschalteten Kapazitätsschaltung basierend auf der ersten und zweiten Phase des geschalteten Kapazitätseingangssignals geschaltet werden.

17. Filter nach Anspruch 14, wobei das geschaltete Kapazitätseingangssignal eine erste und eine zweite Phase beinhaltet, und wobei Schalter in der geschalteten Kapazitätsschaltung basierend auf der ersten und zweiten Phase des geschalteten Kapazitätseingangssignals geschaltet werden.

18. Verstärkerschaltung nach Anspruch 8, wobei die Verstärkerschaltung in einem Differenzbetrieb konfiguriert ist.

19. Verstärkerschaltung nach Anspruch 8, des Weiteren umfassend einen Kondensator mit einem Ende, das mit dem Eingang des ersten OTA verbunden ist, und einem gegenüberliegenden Ende, das mit dem Eingang des dritten OTA verbunden ist.

## Revendications

1. Circuit amplificateur pour amplifier des signaux d'entrée capacitifs commutés, comprenant:
un premier amplificateur (53) ayant une entrée et une sortie, ladite entrée étant destinée à recevoir un signal d'entrée capacitif commuté;
un deuxième amplificateur opérationnel à transconductance, OTA, (54) ayant une entrée connectée à ladite sortie dudit premier amplificateur;
un troisième amplificateur (62) ayant une entrée connectée à ladite entrée dudit premier amplificateur et une sortie;
un quatrième amplificateur OTA (66) ayant une entrée connectée à ladite sortie dudit troisième amplificateur et une sortie;
une résistance de rétroaction (70) connectée entre ladite entrée et ladite sortie dudit quatrième OTA; et
un condensateur (56) connecté à ladite sortie dudit quatrième OTA et à ladite entrée dudit deuxième OTA.

2. Circuit amplificateur selon la revendication 1, comprenant en outre N amplificateurs OTA (101 - 101M) connectés en série, dans lequel N est un nombre entier supérieur à zéro et dans lequel une entrée d'un premier desdits N amplificateurs OTA est connectée à ladite sortie dudit premier amplificateur et la sortie d'un dernier desdits N amplificateurs OTA est connectée à ladite entrée dudit deuxième amplificateur OTA.

3. Circuit amplificateur selon la revendication 1, dans lequel ladite entrée dudit troisième amplificateur est couplée de manière capacitive audit premier amplificateur et comprenant en outre un circuit capacitif commuté (131) qui se connecte de manière sélective à ladite entrée et à ladite sortie dudit troisième amplificateur.

4. Circuit amplificateur selon la revendication 3, dans lequel ledit circuit capacitif commuté comprend:
un premier commutateur (132) ayant une première borne connectée à ladite entrée dudit troisième amplificateur;
un deuxième commutateur (134) ayant une première borne connectée à ladite sortie dudit troisième amplificateur; et
un condensateur (136) ayant une extrémité connectée auxdites deuxièmes bornes dudit premier commutateur et dudit deuxième commutateur.

5. Convertisseur numérique-analogique comprenant le circuit amplificateur de la revendication 3 et comprenant en outre un circuit qui génère un signal d'entrée à capacitance commutée qui est saisi dans ladite entrée dudit circuit amplificateur.

6. Convertisseur numérique-analogique comprenant le circuit amplificateur de la revendication 3 et comprenant en outre un circuit qui génère un signal d'entrée à capacitance commutée qui est saisi dans ladite entrée dudit circuit amplificateur.

7. Filtre comprenant le circuit amplificateur de la revendication 3 et comprenant en outre un circuit qui génère un signal d'entrée à capacitance commutée qui est saisi dans ladite entrée dudit circuit amplificateur.

8. Circuit amplificateur selon la revendication 1, comprenant en outre:
un circuit capacitif commuté (131) qui couple de manière sélective un condensateur à au moins l'une de ladite entrée dudit troisième amplificateur OTA et de ladite sortie du troisième amplificateur OTA.

9. Circuit amplificateur selon la revendication 8, dans lequel ledit circuit capacitif commuté comprend:
un premier commutateur (132) ayant une première borne connectée à ladite entrée dudit troisième amplificateur OTA;
un deuxième commutateur (134) ayant une première borne connectée à ladite sortie dudit troisième amplificateur; et
un condensateur (136) ayant une extrémité connectée aux deuxièmes bornes dudit premier commutateur et dudit deuxième commutateur.

10. Circuit amplificateur selon la revendication 8, comprenant en outre un condensateur ayant une extrémité connectée à ladite entrée dudit premier amplificateur OTA et une extrémité opposée connectée à ladite sortie dudit deuxième amplificateur OTA.

11. Circuit amplificateur selon la revendication 8, comprenant en outre N amplificateurs OTA supplémentaires (182-1-182-X) connectés en série entre ladite sortie dudit premier amplificateur OTA et ladite entrée dudit deuxième amplificateur OTA.

12. Convertisseur numérique-analogique comprenant le circuit amplificateur de la revendication 8 et comprenant en outre un circuit qui génère un signal d'entrée à capacitance commutée qui est saisi dans ladite entrée dudit premier amplificateur OTA.

13. Convertisseur numérique-analogique comprenant le circuit amplificateur de la revendication 8 et comprenant en outre un circuit qui génère un signal d'entrée à capacitance commutée qui est saisi dans ladite entrée dudit premier amplificateur OTA.

14. Filtre comprenant le circuit amplificateur de la revendication 8 et comprenant en outre un circuit qui génère un signal d'entrée à capacitance commutée qui est saisi dans ladite entrée dudit premier amplificateur OTA.

15. Convertisseur numérique-analogique selon la revendication 12, dans lequel ladite entrée de capacité commutée le signal comprend une première phase et une deuxième phase et dans lequel des commutateurs dans ledit circuit capacitif commuté sont commutés sur la base de ladite première phase et de ladite deuxième phase dudit signal d'entrée à capacitance commuté.

16. Convertisseur numérique-analogique selon la revendication 13, dans lequel ledit signal d'entrée à capacité commutée comprend une première phase et une deuxième phase et dans lequel des commutateurs dans ledit circuit capacitif commuté sont commutés sur la base de ladite première phase et de ladite deuxième phase dudit signal d'entrée à capacitance commuté.

17. Convertisseur numérique-analogique selon la revendication 14, dans lequel ledit signal d'entrée à capacité commutée comprend une première phase et une deuxième phase et dans lequel des commutateurs dans ledit circuit capacitif commuté sont commutés sur la base de ladite première phase et de ladite deuxième phase dudit signal d'entrée à capacitance commuté.

18. Circuit amplificateur selon la revendication 8, dans lequel ledit circuit amplificateur est configuré dans un mode différentiel.

19. Circuit amplificateur selon la revendication 8, comprenant en outre un condensateur ayant une extrémité connectée à ladite entrée dudit premier amplificateur OTA et une extrémité opposée connectée à ladite entrée dudit troisième amplificateur OTA.
